# EUROPEAN PATENT SPECIFICATION

(11) **EP 1 921 410 B1**
(45) Date of publication and mention of the grant of the patent: **04.11.2009**
(21) Application number: 07017988.2
(22) Date of filing: 13.09.2007
(51) Int. Cl.: F28D 15/02

(54) **Combined assembly of fixing base and heat pipe**
Anordnung aus Wärmerohr und Basisplatte
Ensemble combiné de base de fixation et caloduc

(30) Priority: 10.11.2006 CN 200620149000 U
(43) Date of publication of application: 14.05.2008
(73) Proprietor: Golden Sun News Techniques Co., Ltd., Taipei County 248 (TW); CPUMATE INC., Taipei County 248 (TW)
(72) Inventor: Cheng, Chih-Hung, Wugu Township Taipei County 248 (TW); Hsu, Ken, Wugu Township Taipei County 248 (TW)
(74) Representative: TER MEER - STEINMEISTER & PARTNER GbR

(56) References cited:
- JP-A- 2001 135 966
- JP-A- 2001 248 982
- US-A1- 2004 035 558
- US-A1- 2004 188 080
- US-A1- 2007 151 711
- US-B1- 7 093 648

## Description

### BACKGROUND OF THE INVENTION

### 1. Field of the Invention

The present invention relates to a combined assembly of a fixing base and heat pipe, and in particular to a combined assembly for providing heat conduction for electronic elements.

### 2. Description of Prior Art

With respect to the heat conduction of electronic heat-generating elements, the industry nowadays utilizes heat pipes because of their high heat-transferring capacity, light weight, simple structure and versatility. The heat pipe can transfer a large amount of heat and thus is very suitable for meeting the demands for the heat conduction of the electronic products. The heat pipe is usually combined with a fixing base, thereby increasing the contact area between the heat pipe and the electronic heat-generating element efficiently. Therefore, whether the combination between the fixing base and the heat pipe is good or bad may affect the heat-transferring performance and the stability in fixation directly. Thus, it is an important issue in this art to enhance the firm combination and tight contact between the fixing base and the heat pipe.

Conventional combined assembly of the fixing base and the heat pipe includes a fixing base and a heat pipe. The fixing base has a plate body. The bottom surface of the plate body is formed with a rectangular opening trough. The heat pipe has an end to be heated and a heat-releasing end. The end to be heated is accommodated in the opening trough, and the heat-releasing end is formed above the plate body. A portion of the end to be heated abuts against and contacts the inner wall of the opening trough, while the other portion thereof is flush with the bottom surface of the fixing base. With the above arrangement, the combined assembly of the fixing base and the heat pipe can be formed.

However, in practical use, the conventional combined assembly of the fixing base and the heat pipe still has the problem as follows. Since the left and right inner walls of the opening trough of the fixing base are vertical, the fixing force between the fixing base and the heat pipe after compression and combination is very small. As a result, the heat pipe and the fixing base can be detached from each other or get loosened due to the collision occurred during the assembling procedure (or during the process of combining with heat-dissipating pieces). Therefore, the heat-transferring performance and the stability in fixation are poor, and thus needs to be improved.

### SUMMARY OF THE INVENTION

The present invention is to provide a combined assembly of a fixing base and heat pipe. One end of the heat pipe is accommodated in an opening trough of the fixing base to abut against the inner walls of the opening trough, enlarging portions and loose-proof sections. In this way, the stability in fixation and tight contact between the fixing base and the heat pipe can be assured so as to enhance the total heat-transferring performance.

The present invention is to provide a combined assembly of a fixing base and heat pipes, which includes a fixing base and at least one heat pipe. The fixing base has a plate body. The bottom surface of the plate body is formed with opening troughs. Both sides of the opening trough are provided with longitudinal through holes that penetrate through the plate body. The inner wall of the opening trough is formed with enlarging portions. The width of the enlarging portion is larger than that of a mouth of the opening trough. The mouth of the opening trough is provided with loose-proof sections. The heat pipe has an end to be heated and a heat-releasing end. The heat-releasing end penetrates to the outside of the through hole of the fixing base, and the end to be heated is accommodated in the opening trough. A portion of the end to be heated abuts against and contacts the inner walls of the opening trough, the enlarging portions and the loose-proof sections, and the other portion thereof is flush with the bottom surface of the fixing base.

### BRIEF DESCRIPTION OF THE DRAWINGS

Fig. 1 is a perspective view showing the external appearance of the fixing base of the present invention;
Fig. 2 is a cross-sectional view of the fixing base of the present invention;
Fig. 3 is an exploded perspective view showing the fixing base and the heat pipe of the present invention;
Fig. 4 is an assembled cross-sectional view showing a state before the fixing base and the heat pipe of the present invention are not pressed together;
Fig. 5 is an assembled cross-sectional view showing a state after the fixing base and the heat pipe of the present invention have been pressed together;
Fig. 6 is an assembled cross-sectional view showing that the present invention is applied to a heat-dissipating device of a heat-generating element;
Fig. 7 is a perspective view showing the external appearance of the fixing base of another embodiment of the present invention;
Fig. 8 is an assembled cross-sectional view showing the fixing base and the heat pipe of the present invention; and
Fig. 9 is a cross-sectional view taken along the line 9-9 in Fig. 8.

### DETAILED DESCRIPTION OF THE INVENTION

The detailed description and the technical contents of the present invention will be made with reference to the accompanying drawings. However, it should be understood that the drawings are illustrative only, but not used to limit the present invention.

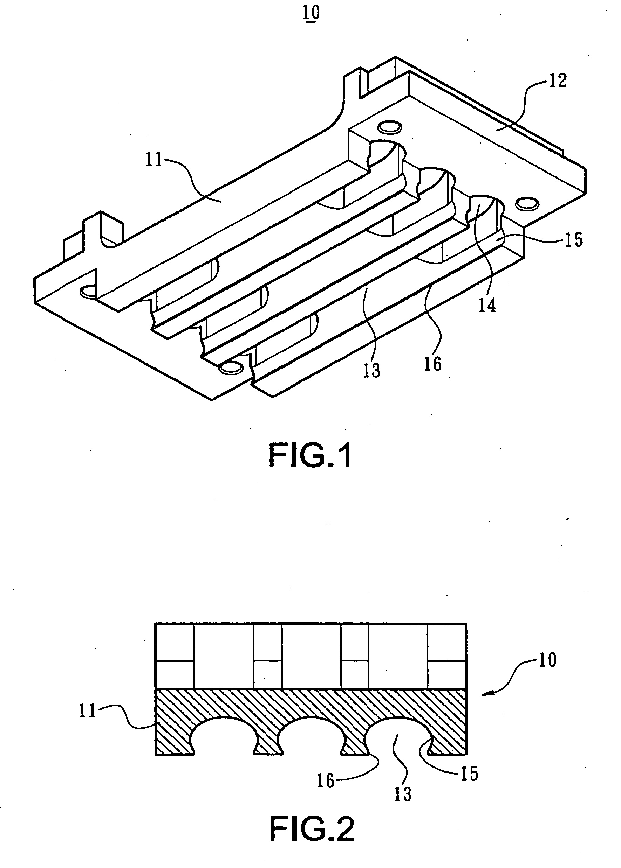

Fig. 1 and Fig. 2 are the perspective view and the cross-sectional view showing the fixing base of the present invention. The present invention provides a combined assembly of a fixing base and a heat pipe. The fixing base 10 can be made of aluminum, copper or non-metallic materials. The fixing base has a rectangular plate body 11 and two L-shaped extending blocks 12 protruding upwardly and outwardly from both ends of the plate body 11. The bottom surface of the plate body 11 is formed with a plurality of transverse opening troughs 13 that are parallel to one another. Both sides of the opening trough 13 are provided with longitudinal through holes 14 that penetrate through the plate body 11. The inner wall of each opening trough 13 is formed with an enlarging portion 15. In the present embodiment, the enlarging portion 15 is two transverse recessed arcs that correspond to each other. In the horizontal direction, the transverse width of the enlarging portion 15 is larger than that of the mouth of the opening trough 13. Further, the month of the opening trough 13 is formed with two loose-proof sections 16 that correspond to each other.

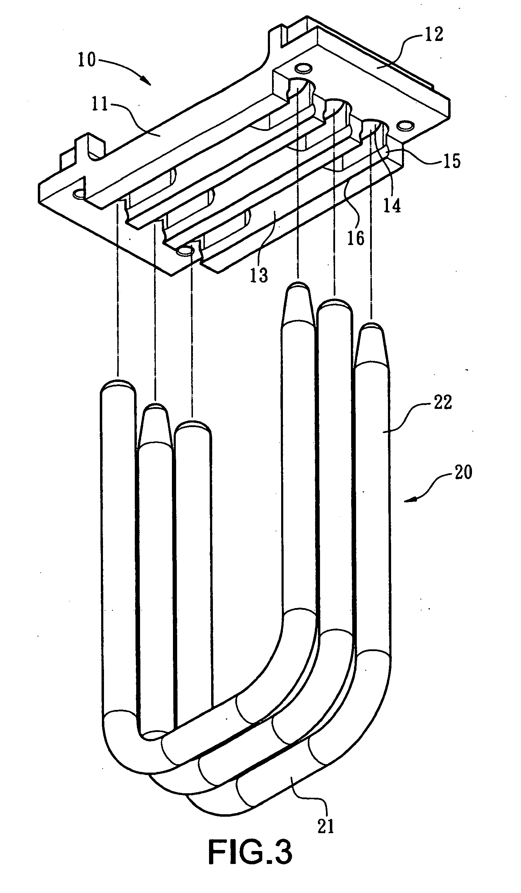

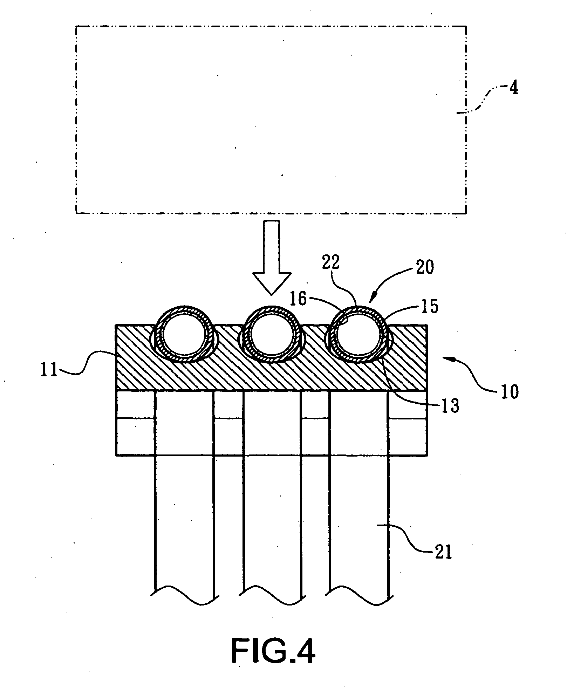

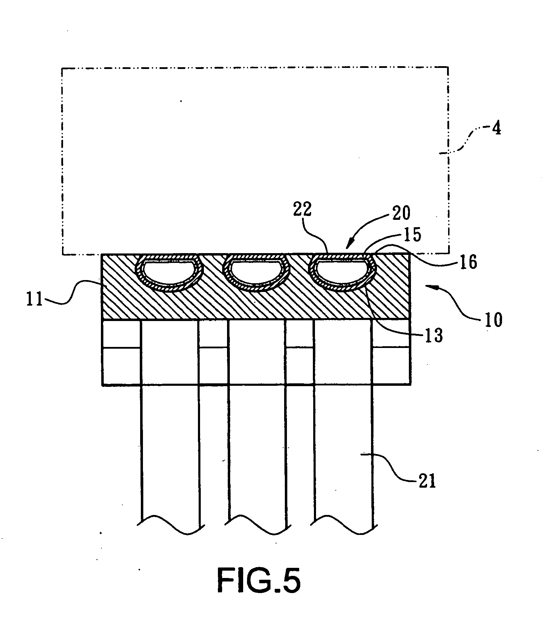

Please refer to Figs. 3 to 5, in which Fig. 3 is an exploded perspective view showing the fixing base and the heat pipe of the present invention, Fig. 4 is an assembled cross-sectional view showing a state before the fixing base and the heat pipe of the present invention are not pressed together, and Fig. 5 is an assembled cross-sectional view showing a state after the fixing base and the heat pipe of the present invention have been pressed together. The fixing base 10 of the present invention is connected and combined with heat pipes 20. Single heat pipe or a plurality of heat pipes 20 may be provided. The number of the heat pipes depends on the desired heat-conducting value. In the present embodiment, there are three heat pipes. The heat pipe 20 may be formed into L-shaped, U-shaped or other suitable shapes. The heat pipe 20 has a heat-absorbing end 21 and a heat-releasing end 22. The interior of the heat pipe is filled with a capillary structure and a working fluid. Via the heat-transferring mechanism between the vapor phase and the liquid phase of the working fluid, a rapid heat-transferring effect can be achieved. The heat-releasing end 22 penetrates through the outside of the through hole 14 of the fixing base 10, while the heat-absorbing end 21 is accommodated in the opening trough 13. A portion of the heat-absorbing end 21 abuts against and contacts the inner walls of the opening trough 13, the enlarging portion 15 and the loose-proof section 16. The other portion thereof is flush with the bottom surface of the fixing base 10.

During the assembling process, the heat-releasing end 22 of the heat pipe 20 penetrates through the through hole 14 of the fixing base 10. The lower half portion of the heat-absorbing end 21 is accommodated in the opening trough 13 of the fixing base 10, and the upper half portion thereof is exposed to the outside of the opening trough 13. A pressing tool 4 is used to press the upper half portion of each heat pipe 20. In this way, the external shape of the heat pipe 20 is compressed to deform, and thus abuts against and contacts the inner walls of the opening trough 13, the enlarging portion 15 and the loose-proof section 16 of the fixing base 10. At the same time, the top surface of the heat pipe 20 is flush with the bottom surface of the fixing base 10 (as shown in Fig. 5). Finally, a grinding tool such as emery cloth or emery wheel is used to grind the fixing base 10 and the heat-absorbing end 21 of the heat pipe 20. Since the loose-proof section 16 is formed in the mouth of the opening trough 13, the loose-proof section 16 can still hold the heat-absorbing end 21 of the heat pipe 20 tightly even though the fixing base 10 and the heat pipe 20 have been ground. Thus, the loosening or detachment between the fixing base 10 and the heat pipe 20 can be prevented efficiently.

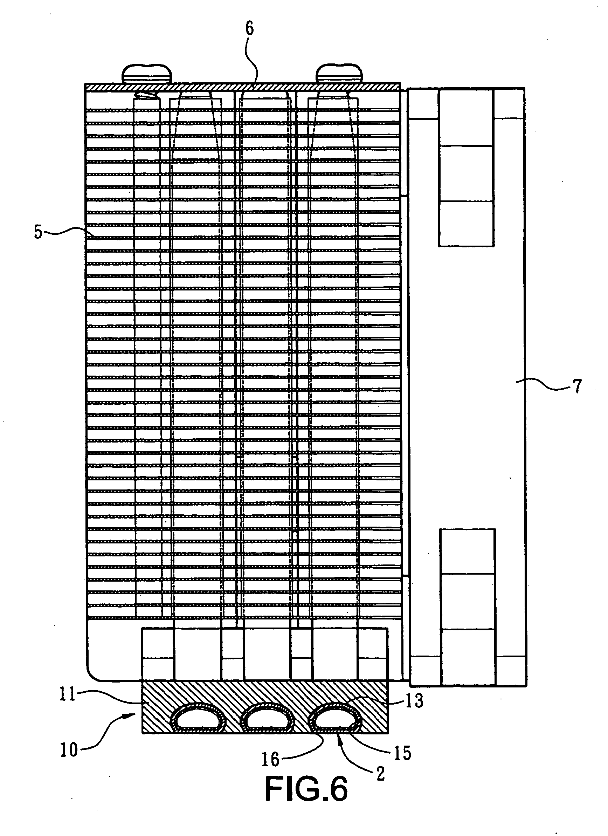

With reference to Fig. 6, it is an assembled cross-sectional view showing that the present invention is applied to a heat-dissipating device of a heat-generating element. In the present invention, the heat-releasing end 22 of the heat pipe 20 can be connected with a plurality of heat-dissipating pieces 5. Since the connection between the fixing base 10 and the heat pipe 20 is firm, during the process of connecting the heat-dissipating pieces 5 with the heat pipe 20, the heat pipe 20 cannot be pushed by an axial force and thus the loosening and detachment between the heat pipe 20 and the fixing base 10 cannot occur. Further, a covering frame 6 covers at the outside of the heat-dissipating pieces 5. One side of the covering frame 6 is connected to a fan 7. Via the above arrangement, a heat-dissipating device is obtained.

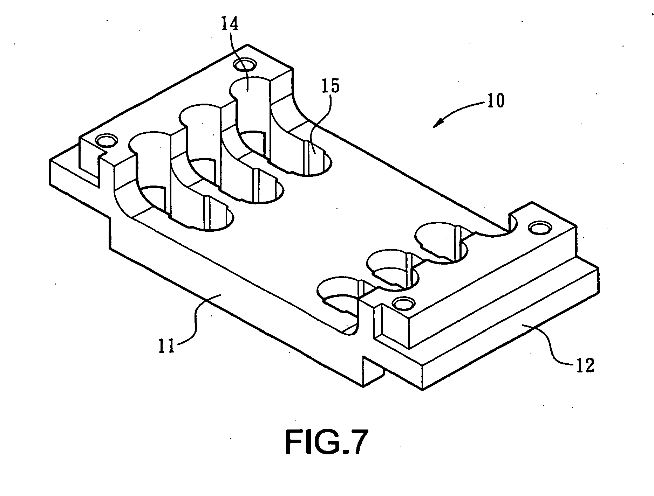

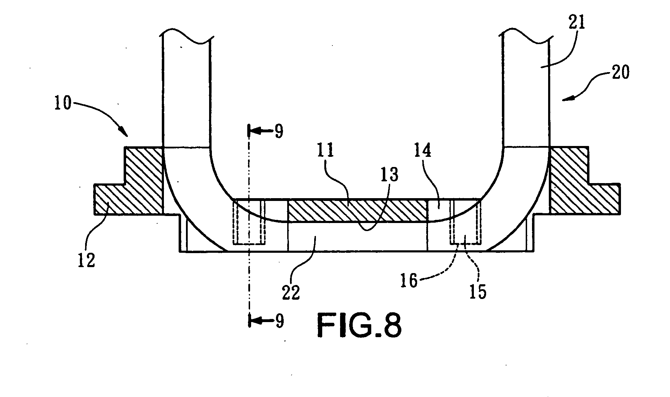

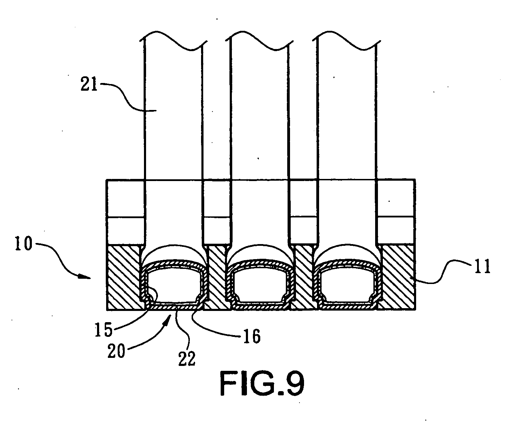

Please refer to Figs. 7 to 9, in which Fig. 7 is a perspective view showing the external appearance of the fixing base of another embodiment of the present invention, Fig. 8 is an assembled cross-sectional view showing the fixing base and the heat pipe of the present invention, and Fig. 9 is a cross-sectional view taken along the line 9-9 in Fig. 8. In addition to the aspect shown in the previous embodiment, the fixing base 10 of the present invention can be processed to have an enlarging portion 15 on the inner wall of the opening trough 13. The enlarging portion 15 is two longitudinal recessed troughs that correspond to each other and extend upwardly over the top of the through hole 14. The mouth of the opening trough 13 is formed with two loose-proof sections 16 that correspond to each other. During the process of combining the heat pipe 20 with the fixing base 10, after the heat-absorbing end 21 of the heat pipe 20 is pressed, the external shape of the heat-absorbing end 21 of the heat pipe 20 will be pressed to deform, and thus abuts against and contacts the inner walls of the opening trough 13, the enlarging portion 15 and the loose-proof section 16 of the fixing base 10. At the same time, the bottom surface of the heat-absorbing end 21 of the heat pipe 20 is flush with the bottom surface of the fixing base 10.

## Claims

1. A combined assembly of a fixing base and heat pipe, comprising:
a fixing base (10) having a plate body (11), a bottom surface of the plate body (11) being formed with an opening trough (13), the opening trough (13) being provided with a longitudinal through hole (14) that penetrate through the plate body (11), an inner wall of the opening trough (13) being formed with an enlarging portion (15), the width of the enlarging portion (15) being larger than that of a mouth of the opening trough (13), the mouth of the opening trough (13) being formed with a loose-proof section (16); and
a heat pipe (20) having a heat-absorbing end (21) and a heat-releasing end (22), the heat-releasing end (22) penetrating out of the through hole (14) of the fixing base (10), the heat-absorbing end (21) being accommodated in the opening trough (13), a portion of the heat-absorbing end (21) abutting against and contacting the inner walls of the opening trough (13), the enlarging portion (15) and the loose-proof section (16), and an exposed portion of the heat-absorbing end being flush with the bottom surface of the fixing base (10).

2. The combined assembly of a fixing base and heat pipes according to claim 1, wherein the fixing base (10) has a rectangular plate body (11) and two extending blocks (12) protruding upwardly and outwardly from both ends of the plate body (11), respectively.

3. The combined assembly of a fixing base and heat pipes according to claim 1, wherein the enlarging portion (15) is formed by two correspondingly transverse recessed arcs.

4. The combined assembly of a fixing base and heat pipes according to claim 1, wherein the enlarging portion (15) is formed by two correspondingly longitudinal recessed troughs and extends upwardly to a top of the through hole (14).

5. The combined assembly of a fixing base and heat pipes according to claim 1, wherein the heat pipe (20) is formed into a L-shape.

6. The combined assembly of a fixing base and heat pipes according to claim 1, wherein the heat pipe (20) is formed into a U-shape.

## Patentansprüche

1. Kombinierte Anordnung aus einer Befestigungsbasis und einem Wärmerohr, die umfasst:
eine Befestigungsbasis (10) mit einem Plattenkörper (11), wobei eine untere Oberfläche des Plattenkörpers (11) mit einem offenen Kanal (13) ausgebildet ist, wobei der offene Kanal (13) mit einem longitudinalen Durchgangsloch (14) versehen ist, das den Plattenkörper (11) durchdringt, wobei eine Innenwand des offenen Kanals (13) mit einem erweiterten Abschnitt (15) ausgebildet ist, wobei die Weite des erweiterten Abschnitts (15) größer ist als jene einer Öffnung des offenen Kanals (13), wobei die Öffnung des offenen Kanals (13) mit einem Ablösungsschutzabschnitt (16) ausgebildet ist; und
ein Wärmerohr (20) mit einem Wärme absorbierenden Ende (21) und einem Wärme abgebenden Ende (22), wobei das Wärme abgebende Ende (22) aus dem Durchgangsloch (14) der Befestigungsbasis (10) austritt, wobei das Wärme absorbierende Ende (21) in dem offenen Kanal (13) aufgenommen ist, wobei ein Abschnitt des Wärme absorbierenden Endes (21) an den Innenwänden des offenen Kanals (13), des Erweiterungsabschnitts (15) und des Ablösungsschutzabschnitts (16) anliegt und damit in Kontakt ist und ein freiliegender Abschnitt des Wärme absorbierenden Endes mit der unteren Oberfläche der Befestigungsbasis (10) bündig ist.

2. Kombinierte Anordnung aus einer Befestigungsbasis und Wärmerohren nach Anspruch 1, wobei die Befestigungsbasis (10) einen rechtwinkligen Plattenkörper (11) und zwei Verlängerungsblöcke (12), die von den beiden Enden des Plattenkörpers (11) nach oben und nach außen vorstehen, aufweist.

3. Kombinierte Anordnung aus einer Befestigungsbasis und Wärmerohren nach Anspruch 1, wobei der Erweiterungsabschnitt (15) durch zwei entsprechend quer ausgesparte Bögen gebildet ist.

4. Kombinierte Anordnung aus einer Befestigungsbasis und Wärmerohren nach Anspruch 1, wobei der Erweiterungsabschnitt (15) durch zwei entsprechend in Längsrichtung verlaufende ausgesparte Kanäle gebildet ist und sich nach oben zu einer Oberseite des Durchgangslochs (14) erstreckt.

5. Kombinierte Anordnung aus einer Befestigungsbasis und Wärmerohren nach Anspruch 1, wobei das Wärmerohr (20) L-förmig ausgebildet ist.

6. Kombinierte Anordnung aus einer Befestigungsbasis und Wärmerohren nach Anspruch 1, wobei das Wärmerohr (20) U-förmig ausgebildet ist.

## Revendications

1. Ensemble combiné formé d'une base de fixation et d'un tube caloporteur, comprenant :
une base de fixation (10) ayant un corps de plaque (11), une surface de fond du corps de plaque (11) étant formée avec une goulotte ouverte (13), la goulotte ouverte (13) étant pourvue d'un trou traversant longitudinal (14) qui pénètre à travers le corps de plaque (11), une paroi intérieure de la goulotte ouverte (13) étant formée avec une portion élargie (15), la largeur de la portion élargie (15) étant supérieure à celle d'une embouchure de la goulotte ouverte (13), l'embouchure de la goulotte ouverte (13) étant formée avec une section (16) destinée à s'opposer aux pertes ; et
un tube caloporteur (20) ayant une extrémité d'absorption de chaleur (21) et une extrémité de dégagement de chaleur (22), l'extrémité de dégagement de chaleur (22) pénétrant en sortant du trou traversant (14) de la base de fixation (10), l'extrémité d'absorption de chaleur (21) étant logée dans la goulotte ouverte (13), une portion de l'extrémité d'absorption de chaleur (21) venant en butée et en contact avec les parois intérieures de la goulotte ouverte (13), la portion élargie (15) et
la section (16) destinée à s'opposer aux pertes, ainsi qu'une portion exposée de l'extrémité d'absorption de chaleur, étant en affleurement avec la surface du fond de la base de fixation (10).

2. Ensemble combiné formé d'une base de fixation et de tubes caloporteurs selon la revendication 1, dans lequel la base de fixation (10) possède un corps en plaque rectangulaire (11) et deux blocs en extension (12) qui se projettent vers le haut et vers le bas depuis les deux extrémités du corps en plaque (11), respectivement.

3. Ensemble combiné formé d'une base de fixation et de tube caloporteur selon la revendication 1, dans lequel la portion élargie (15) est formé par deux axes évidés correspondant transversaux.

4. Ensemble combiné formé d'une base de fixation et de tubes caloporteurs selon la revendication 1, dans lequel la portion élargie (15) est formée par deux goulottes évidées longitudinales correspondantes, et s'étend vers le haut jusqu'à un sommet du trou traversant (14).

5. Ensemble combiné formé d'une base de fixation et de tubes caloporteurs selon la revendication 1, dans lequel le tube caloporteur (20) est formé avec une forme en "L".

6. Ensemble combiné formé d'une base de fixation et de tubes caloporteurs selon la revendication 1, dans lequel le tube caloporteur (20) est formé sous une forme en "U".
